# EUROPÄISCHE PATENTSCHRIFT

(11) **EP 0 727 639 B1**
(45) Veröffentlichungstag und Bekanntmachung des Hinweises auf die Patenterteilung: **05.07.2000**
(21) Anmeldenummer: 96101636.7
(22) Anmeldetag: 06.02.1996
(51) Int. Cl.: G01B 7/34

(54) **Verfahren zur chemisch differenzierenden Abbildung mittels Rasterkraftmikroskopie**
Method of chemically differentiated imaging by means of atomic force microscopy
Procédé de représentation de différences chimiques à l'aide d'un microscope à force atomique

(30) Priorität: 15.02.1995 DE 19504855
(43) Veröffentlichungstag der Anmeldung: 21.08.1996
(73) Patentinhaber: BASF AKTIENGESELLSCHAFT, 67056 Ludwigshafen (DE)
(72) Erfinder: Horn, Dieter, Dr., D-69120 Heidelberg (DE); Keller, Harald, Dr., D-67069 Ludwigshafen (DE); Schrepp, Wolfgang, Dr., D-69118 Heidelberg (DE); Akari, Sabri, Dr., D-67240 Bobenheim-Roxheim (DE)

(56) Entgegenhaltungen:
- EP-A- 0 511 662
- EP-A- 0 527 370
- EP-A- 0 540 839
- GB-A- 2 235 049
- INTERNATIONAL CONFERENCE ON SCANNING TUNNELING MICROSCOPY (STM '93), BEIJING, CHINA, 9-13 AUG. 1993, Bd. 12, Nr. 3, ISSN 0734-211X, JOURNAL OF VACUUM SCIENCE & TECHNOLOGY B (MICROELECTRONICS AND NANOMETER STRUCTURES), MAY-JUNE 1994, USA, Seiten 2215-2218, XP000570797 NAKAGAWA T ET AL: "Atomic force microscope for chemical sensing"
- EUROPHYSICS LETTERS, 1 DEC. 1992, SWITZERLAND, Bd. 20, Nr. 7, ISSN 0295-5075, Seiten 633-638, XP000572453 BARRAT A ET AL: "How are the wetting properties of silanated surfaces affected by their structure? An atomic-force microscopy study"
- IBM TECHNICAL DISCLOSURE BULLETIN, Bd. 37, Nr. 4A, April 1994, NEW YORK, US, Seiten 235-236, XP000446652 ANONYMOUS: "Tip Insulation with Self-Assembled Monolayers"
- APPLIED PHYSICS LETTERS, 28 MARCH 1994, USA, Bd. 64, Nr. 13, ISSN 0003-6951, Seiten 1738-1740, XP000441262 HANSMA P K ET AL: "Tapping mode atomic force microscopy in liquids"

## Beschreibung

Die vorliegende Erfindung betrifft ein Verfahren zur chemisch differenzierenden Abbildung mittels Rasterkraftmikroskopie, wobei chemisch modifizierte Sonden eingesetzt werden.

Mit der Erfindung der Rastertunnelmikroskopie durch Binning und Rohrer (vgl. G. Binning, H. Rohrer, Ch. Gerber und E. Weibel; Phys. Rev. Lett. 49 (1982) 57) wurde es möglich, von leitfähigen Oberflächen die Topographie (ein Relief) mit atomarer Auflösung unter normalen Laborbedingungen zu erhalten. Vier Jahre später (vgl. G. Binning, C.F. Quate und Ch. Gerber; Phys. Rev. Lett. 56 (1986) 930) wurde mit der Rasterkraftmikroskopie ein Verfahren gefunden, welches mit ähnlicher Auflösung auch nicht leitende Proben zu untersuchen erlaubt (EP-A-0 511 662 und GB-A-2 235 049).

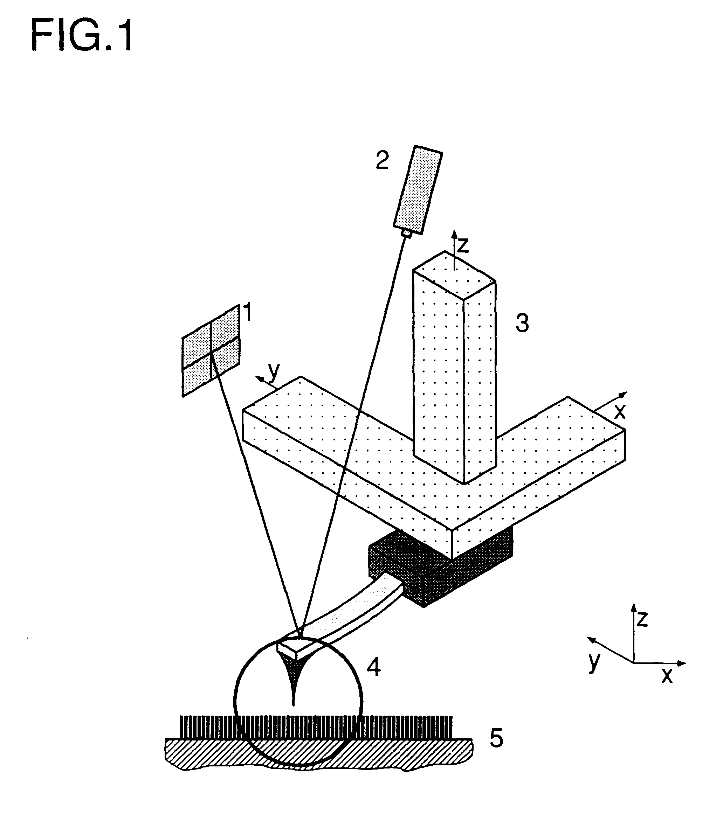

Bei der hauptsächlich verwendeten Betriebsweise der Rasterkraftmikroskopie (s. Fig. 1) wird eine an einem Hebelarm befindliche Spitze aus Silicium oder Siliciumnitrid in einem sehr geringen Abstand bei konstanter Abstoßungskraft über die Probe geführt. Die Vorgabe der Auflagekraft erfolgt indirekt über die Verbiegung des Hebelarmes, welche über eine Art Lichtzeiger gemessen wird. Trifft die Spitze nun auf eine Erhebung, so wird der Abstand zur Probenoberfläche kleiner. Da aber bei dieser Annäherung die van der Waalssche Abstoßungskraft steigt, wird durch Zurückführen der Probe mit Hilfe eines Piezoverstellers die ursprüngliche Abstoßungskraft wieder hergestellt. Das Regelsignal des Piezoverstellers dient zur Rekonstruktion des Höhenprofils der zu untersuchenden Probe. Durch Modulation des Hebelarmes ist es möglich, z.B. auch weiche oder klebrige Proben zu untersuchen. Zwei mögliche Verfahren werden als Tapping- oder Non-Contact-Modus bezeichnet. Beim Tapping liegt die Modulationsfrequenz in der Nähe der Resonanzfrequenz des Hebelarmes (typischerweise 300 bis 500 kHz), die Amplitude beträgt ca. 50 bis 200 nm, die Probenoberfläche wird kurzzeitig berührt. Die typischen Betriebsdaten für den Non-Contact-Modus lauten: Modulationsfrequenz 100 bis 200 kHz, Amplitude um 1 nm. Bei diesem Verfahren wird die Probe nicht berührt.

Ein Nachteil der Rasterkraftmikroskopie ist die Tatsache, daß eine chemische Spezifizierung der Oberfläche , d.h. ein chemisches Abbild der Oberfläche, bisher nicht zu erhalten war. Eine gewisse Abhilfe wurde durch eine spezielle Modulationstechnik gefunden, die es erlaubt hart/weich-Unterschiede (Elastizitäts-Modus) und Kontraste im Reibungsverhalten -im sog. Lateralkraft-Modus) und Kontraste im Reibungsverhalten -im sog. Lateralkraft-Modus, bei dem die Verbiegung des Hebelarmes gemessen wird- auf der Oberfläche darzustellen (vgl. L.F. Chi, M. Anders, H. Fuchs, R.R. Johnston und H. Ringsdorf; Science 259 (1993) 213).

Auch wurde kürzlich über die Erkennung zwischen Ligand-Rezeptor-Paaren berichtet (vgl. E.F. Florin, V.T. Moy und H.E. Gaub; Science 264 (1994) 415).

Nach wie vor blieb im Bereich der Rasterkraftmikroskopie die Aufgabe ungelöst, chemisch unterschiedliche Bereiche auf der Oberfläche nachzuweisen. Ein teilweiser Lösungsansatz wurde jüngst von C.D. Frisbie, L.F. Rozsnyai, A. Noy, M.S. Wrighton und L.M. Lieber in Science 265 (1994) 207 veröffentlicht. In dem dort beschriebenen Experiment wurde eine chemisch modifizierte Spitze verwendet, die über eine chemisch strukturierte Modelloberfläche geführt wurde. Bei Nutzung des Lateralkraftmodus konnte zwischen methyl- und säuregrupppenterminierten Bereichen unterschieden werden. Der Kontrastmechanismus wurde auf die hydrophobe Wechselwirkung zurückgeführt.

Aufgabe der vorliegenden Erfindung ist es, ein Verfahren zur chemisch differenzierenden Abbildung mittels Rasterkraftmikroskopie aufzuzeigen, wobei chemisch modifizierte Sonden eingesetzt werden, ohne den Lateralkraftmodus zu nutzen.

Gegenstand der vorliegenden Erfindung ist ein Verfahren zur chemisch differenzierenden Abbildung mittels Rasterkraftmikroskopie unter Verwendung chemisch modifizierter Sonden nach Anspruch 1 oder 2.

Dieses Verfahren eignet sich auch zur Abbildung technischer Oberflächen (technical surfaces), wie z.B. zur Abbildung rauher oder klebriger Oberflächen sowie von Substanzen mit Klebereigenschaften, zum Speichern und Auslesen von Informationen sowie zur Abbildung von biologischen Proben, z.B. zur Sequenzierung von Proteinen und zur Sequenzierung von DNA- und RNA-Molekülen (Nukleotiden).

Vorteilhafte Ausführungsformen des erfindungsgemäßen Verfahrens bestehen darin, daß die als chemisch modifizierte Sonde eingesetzte Spitze des Rasterkraftmikroskops entweder direkt oder nach Aufbringen einer Metall- oder Oxidschicht mit einer oder mehreren Substanzen beschichtet wird, die selektive Wechselwirkungen zur zu untersuchenden Oberfläche aufweisen, wobei als die die Spitze zu modifizierende Substanz ein Thiol mit zusätzlicher saurer oder basischer Funktionalität, ein Thiol mit zusätzlicher Nukleinbasenfunktionalität, ein Disulfid mit zusätzlicher saurer oder basicher Funktionalität, ein Disulfid mit zusätzlicher Nukleinbasenfunktionalität, ein Silan mit zusätzlicher saurer oder basischer Funktionalität oder ein Silan mit zusätzlicher Nukleinbasenfunktionalität eingesetzt werden kann.

Eine weitere vorteilhafte Ausführungsform des erfindungsgemäßen Verfahrens besteht darin, daß die Spitze des Rasterkraftmikroskops mit einem Polykation, mit einem Polyanion, mit einer organischen oder anorganischen Säure, mit einer organischen oder anorganischen Base, mit einer Lewis-Säure bzw. mit einer Lewis-Base beschichtet ist, wobei Säure bzw. Base auch in polymerer Form vorliegen können.

Überraschenderweise wurde gefunden, daß es auch im oben beschriebenen Normalmodus -d.h. bei Registrierung der Topographie- möglich ist, die erfindungsgemäße Aufgabe einer chemischen Abbildung mit Hilfe der Rasterkraftmikroskpie zu lösen. Vorteile des Normalkraft-Modus sind, daß keine zusätzliche apparative Ausrüstung notwendig ist (praktisch alle Geräte sind dafür eingerichtet) und daß in der Regel bei dieser Betriebsweise die höchste laterale Auflösung erreicht wird.

Für die Lösung der erfindungsgemäßen Aufgabe einer chemischen Abbildung kommt auch die Nutzung des Elastizitäts-, Tapping- oder Non-Contact-Modus mit modifizierter Spitze in Frage.

Das erfindungsgemäße Verfahren sei im folgenden beispielhaft erläutert.

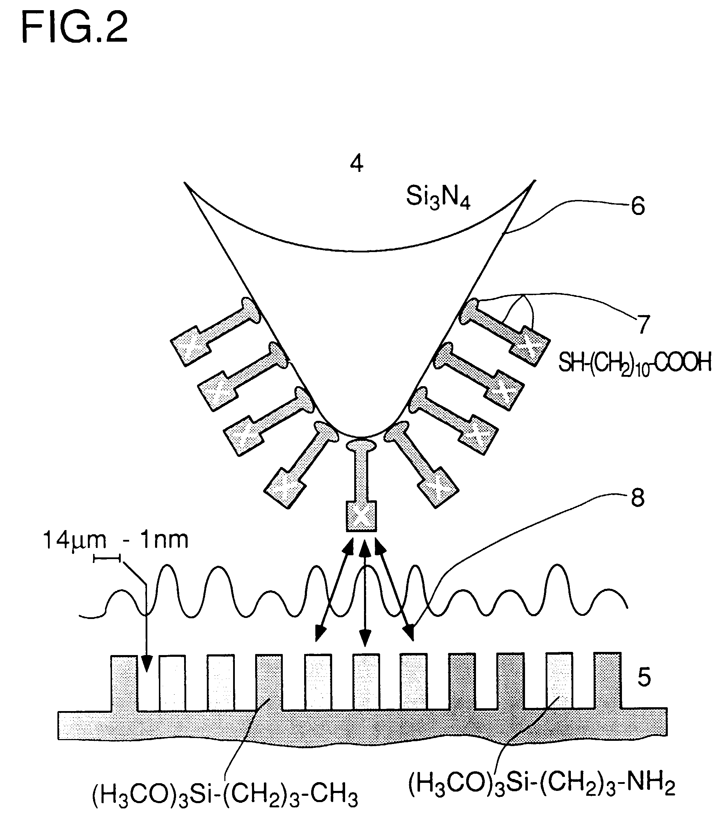

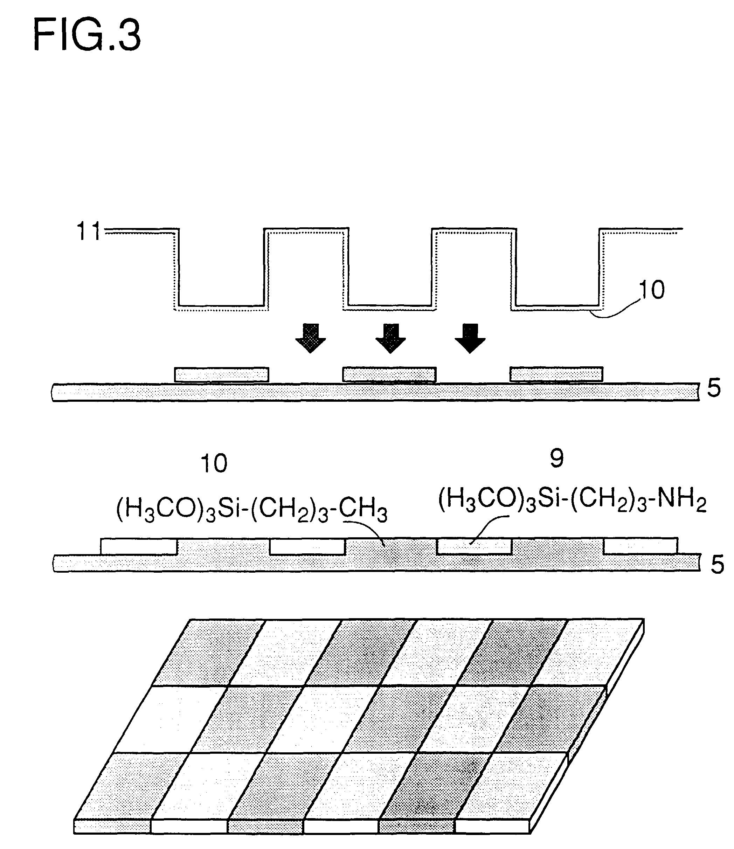

Es läßt sich beispielsweise wie folgt verfahren: Eine Siliciumnitridspitze wird mit Gold bedampft und nach dem sog. Self-Assembly-Verfahren (= Adsorption aus der flüssigen Phase; vgl. H. Keller, W. Schrepp u. H. Fuchs; Thin Solid Films 210/211 (1992) 799) mit einer Thiolcarbonsäure beschichtet (vgl. Fig. 2). Diese modifizierte Spitze wird als spezifische Sonde benutzt. Eine Modellprobe wurde z.B. folgendermaßen hergestellt: Eine Maske wurde mit Butyl-trimethoxy-Silan beschichtet. Durch Aufpressen auf einen Siliciumwafer wurden nach dem Muster eines Schachbrettes Bereiche erzeugt, die Methylendgruppen enthalten. Durch Spülen wurden überschüssige Moleküllagen entfernt, so daß ca. eine Monolage des Silans auf der Oberfläche zurückblieb. Die kovalente Fixierung auf dem Substrat erfolgte durch Tempern. Durch Eintauchen des so teilweise beschichteten Wafers in eine verdünnte Lösung von Aminopropyltrimethoxysilan wurden durch Adsorption die bisher unbeschichteten Bereiche so belegt, daß hier eine aminotermi-nierte Oberfläche entstand; d.h. als zu untersuchende Probe liegt ein schachbrettartiges Muster von amino- und methylterminierten Silanmonolagen mit vernachlässigbarer Höhendifferenz und somit keinen Topographieunterschieden vor (vgl. Fig. 3).

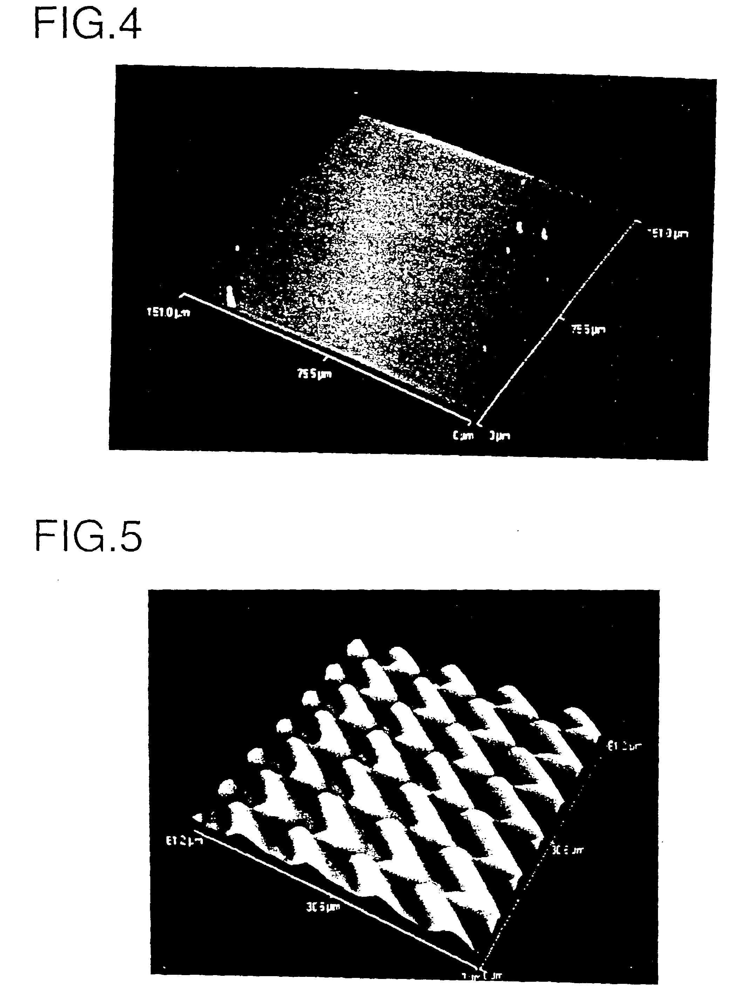

Wird die so hergestellte Probe mit einer normalen, unmodifizierten Spitze im Normalkraft-Modus untersucht, erhält man im Topographiebild der Probe eine glattte Oberfläche (vgl. Fig. 4); die Probe enthält ja keine Höhenunterschiede, es ist keine Struktur erkennbar.

Bei Benutzung der modifizierten Spitze hingegen wird auch im Normalkraft-Modus der Rasterkraftmikroskopie die Struktur der Probe sichtbar (vgl. Fig. 5).

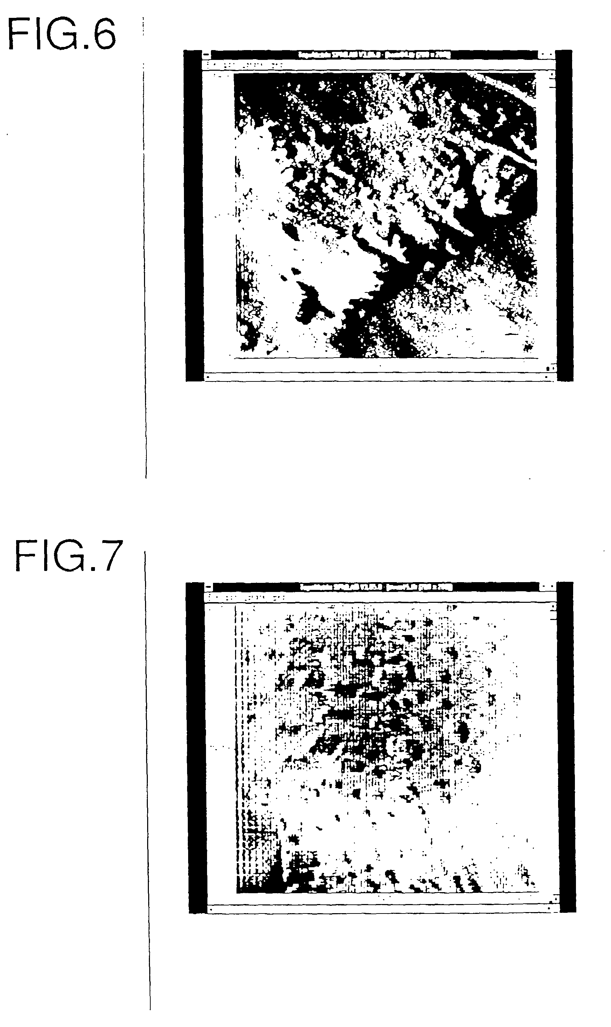

Des weiteren wurde überraschenderweise gefunden, daß das erfindungsgemäße Verfahren auch vorteilhaft zur Untersuchung rauherer, sogar technischer Proben eingesetzt werden kann. Als Beispiel ist in Fig. 6 eine Haaroberfläche gezeigt, welche mit sogenannten Conditionerprodukten behandelt und anschließend gespült wurde. Hierbei bleibt u.U. eine sehr dünne Polymerschicht auf dem Haar zurück, die bewirkt, daß das Haar auch in nassem Zustand kämmbar ist. Bei Untersuchung mit unmodifizierten Spitzen ist die Polymerbedeckung praktisch nicht nachweisbar, wohl aber bei Benutzung modifizierter Spitzen.

In ähnlicher Weise wie Haare lassen sich natürlich auch andere natürliche und synthetische Fasern bezüglich Oberflächenzusammensetzung, Belegung mit Hilfsmitteln, Vorbehandlung wie z.B. durch Schlichten im Textilbereich usw. untersuchen.

Die Charakterisierung des Adsorptionszustandes polymerer Hilfsmittel auf technischen organischen und anorganischen Oberflächen ist von großer industrieller Bedeutung. In diesem Bereich, z.B. bei Sedimentations-, Flockungs- und Papierhilfsmitteln oder Korrosionsschutzmitteln ist ein hoch ortsaufgelöster Nachweis sehr dünner Polymerschichten auf Oberflächen im Sinne einer chemischen Differenzierung von großem Interesse. Ein Beispiel aus diesem Bereich ist in Fig. 7 gezeigt. Hier handelt es sich als Modellsystem um die Bedeckung von Polystyrol-Latexkugeln mit einem Polyelektrolyten, in diesem Falle Polyethylenimin. Die fleckenartige Bedeckung der Styrolkügelchen ist gut zu erkennen.

Das erfindungsgemäße Verfahren zur Unterscheidung verschiedener chemischer Spezies ist auch im Bereich der Datenspeicherung einsetzbar. Wird durch einen vorangehenden physikalischen oder chemischen Schritt dafür gesorgt, daß eine chemische Uneinheitlichkeit in der Probenoberfläche entsteht, so kann diese mit Hilfe des oben beschriebenen Verfahrens ausgelesen werden. Das Einschreiben der Information, d.h. in diesem Falle die chemische Änderung der Oberfläche, kann z.B. durch Licht-, Elektronen- oder Ionenstrahlen geschehen. Auch mit Hilfe der Rastersondenverfahren selbst ist ein Einschreiben von Information denkbar, z.B. durch das Anlegen von Spannungspulsen oder durch katalytische Reaktionen.

Auch Informationen, die mit Hilfe von Licht in ein Matrixpolymer z.B. unter Verwendung von Sulfoniumsalzen eingeschrieben wurden, können mit dem erfindungsgemäßen Verfahren ausgelesen werden.

Viele Problemstellungen zum Nachweis unterschiedlicher Spezies auf Oberflächen sind mit dem erfindungsgemäßen Verfahren lösbar, da es sich hier um ein sehr empfindliches (selbst im Submonolagenbereich) und hochauflösendes Verfahren (bis hinunter zur atomaren Skala) zum Nachweis von Molekülen auf Oberflächen und von Oberflächenstrukturen handelt. Hierzu gehören Kunstoffoberflächen allgemein, die z.B. zur Erzielung einer besseren Haftung mit haftvermittelnden Substanzen versehen sind, deren Verteilung auf der Oberfläche interessiert. Auch Gleitmittel oder Antioxidantien sind in diesem Zusammenhang von Interesse. Bei Polymerblends interessiert z.B.die Verteilung der Hauptkomponenten, d.h. die Morphologie, aber auch die Verteilung von Hilfsmitteln wie z.B. Verträglichkeitsvermittler, Starter usw.

Diese Fragen spielen auch für Polymerdispersionen eine große Rolle, wo es z.B. um den Aufbau der Dispersionsteilchen, um die Verteilung der verschiedenen Komponenten in der Oberfläche und im Querschnitt (bei der Untersuchung von Schnittoberflächen) oder wiederum um die Verteilung von Hilfsmitteln wie z.B. Emulgatoren, geht.

Bei Schaumstoffen läßt sich u.U. auf den Schaumstegen oder Lamellen die Verteilung von Hilfsmitteln untersuchen.

Im Bereich der Katalysatoren läßt sich u.a. die Verteilung der verschiedenen Katalysatorkomponenten in der Oberfläche untersuchen. Vergiftungsphänomene werden u.U. nachweisbar.

Die Belegung von Pigmentoberflächen mit Hilfsstoffen z.B. zur gezielten Beeinflussung des Kristallhabitus ist von großem Interesse und kann mit geeignet modifizierten Spitzen bei hoher örtlicher Auflösung, welche bis hinunter zur molekularen Skala reichen kann, erfolgen. In gleicher Weise ist auch die Untersuchung von Lackoberflächen mit Zielrichtung Nachweis von Verlaufshilfsmitteln, Mikrostruktur der Lackoberfläche, Untersuchung von Fehlstellen (z.B. Kratern), Ursache von Verwitterung usw. möglich. Auch die Verteilung von Hilfsmitteln, Lackrohstoffen usw. auf Leder kann untersucht werden. Das gleiche gilt im Bereich der Drucksysteme, wo z.B. die Verteilung der oleophilen Bereiche auf der Oberfläche von Druckplatten untersucht werden kann. Ebenso kann die Verteilung von Druckfarben auf Oberflächen wie Papier usw. untersucht werden. Untersuchungen im Zusammenhang mit Korrosionsphänomenen auf organischen und anorganischen Oberflächen werden möglich, da diese zu einer veränderten Zusammensetzung der Oberfläche führen, welche durch Abtasten mit modifizierten Spitzen untersucht werden kann.

Weitere Anwendungsmöglichkeiten sind im biologischen und pharmazeutischen Bereich möglich, wo man an das Auffinden von Rezeptorstellen an biologischen Strukturen mit Hilfe wirkstoffmarkierter Spitzen denken kann. Im Sinne der vorliegenden Erfindung ist es auch möglich mittels spezifischer Wechselwirkungen biologisch relevante Bereich auf und in biologischen Strukturen wie z.B. Zellen oder Chromosomen zu erkennen. Zu den detektierbaren Wechselwirkungen zählen z.B. Gen/Antigen-Wechselwirkungen oder allgemeiner Wechselwirkungen zwischen Proteinen und niedermolekularen Wirkstoffen, Oligo- oder Polysacchariden, Lipiden, DNA, RNA sowie Proteinen selbst. Auch das Wechselwirkungsverhalten von Lektinen kann speziell im pflanzlichen Bereich für Nachweis- und Abbildungszwecke genutzt werden.

Generell ist das erfindungsgemäße Verfahren aufgrund der Detektion von Wechselwirkungen für das Screening oder sogar Massenscreening im Wirkstoffbereich einsetzbar. Hierzu ist die Immobilisierung geeigneter Rezeptorstrukturen oder allgemein Targets notwendig, die mit einer wirkstoffmarkierten Spitze abgefahren werden. Auf diese Weise wird ein Wechselwirkungsbild erzeugt. Auch der umgekehrte Fall, daß Rezeptoren an der Spitze angebracht und z.B. Wirkstoffe immobilisiert sind, ist möglich. Im Pflanzenschutzbereich könnte man z.B. an den Nachweis von Pflanzenschutzmitteln auf Blättern als auch auf oder in Pflanzen oder Planzenbestandteilen denken.

Mittels entsprechender Basen ist auch vorstellbar, z.B. eine Sequenzierung an DNA- oder RNA-Strängen vorzunehmen.

Abbildungen in Lösungsmitteln, in Wasser oder unter physiologischen Bedingungen sind ebenfalls möglich.

Die Beschichtung der Spitze muß nicht notwendigerweise in der beschriebenen Weise erfolgen; Ziel ist lediglich das definierte Aufbringen einer oder mehrerer Spezies. So ist z.B. denkbar, die Siliciumnitrid-, Siliciumoxid- oder Siliciumspitze direkt, d.h. ohne Metallzwischenschicht, zu beschichten. Hierzu wären z.B. Silane geeignet. Auch ist denkbar, die Spitze durch Vakuumprozesse (einfaches Aufdampfen sowie Chemical oder Physical Vapour Deposition (CVD oder PVD)) usw. zu beschichten. Auch eine Beschichtung mit Hilfe des Langmuir-Blodgett-Verfahrens wäre möglich. Hierbei könnten insbesonders Mischschichten aus mehreren Spezies aufgebracht werden. Auch ist die Fixierung anderer Prüfkörper wie z.B. Latexkügelchen denkbar. Schichten aus dem Kleberbereich könnten fixiert werden und somit Eigenschaften in diesem Anwendungsbereich untersucht werden.

Die Dicke der Beschichtung kann bis in den Monolagenbereich hinunterreichen. Zur Herstellung modifizierter Spitzen gibt es also eine breite Palette von Möglichkeiten.

Über die in Science 265 (1994) 207 genannte hydrophobe Wechselwirkung hinaus sind im Prinzip praktisch alle vorstellbaren Wechselwirkungskräfte geeignet, für eine chemische, ortsaufgelöste Abbildung herangezogen zu werden. Wie das in Fig. 5 gezeigte Beispiel zeigt, kann die Säure-/Base-Wechselwirkung genutzt werden. In gleicher Weise können elektrostatische, kovalente, disperse usw. Wechselwirkungskräfte bei geeigneter Spitzenmodifikation genutzt werden als auch Wechselwirkungen, die z.B. Charge- Transfer-Übergänge verursachen. Auch die Ausbildung von Wasserstoffbrückenbindungen als auch Donator/Akzeptor-Wechselwirkungen können im Sinne dieser Erfindung zu Abbildungszwecken genutzt werden.

Als Beispiel für die Anwendung des erfindungsgemäßen Verfahrens für das Speichern und Auslesen von Information ist das Einschreiben von Information mit Licht zu nennen. Hierbei kann z.B. ein Gemisch aus einem Matrixpolymer auf Basis eines mit säurelabilen Gruppen modifizierten Poly-p-hydroxystyrols (z.B. mit tert.-Butoxycarbonylgruppen oder tert.-Butoxyacetylgruppen modifizierten Vinylphenoleinheiten) und Sulfoniumsalz mit UV-Strahlung bildmäßig belichtet werden. Entsprechend den angeführten Reaktionsschemen (a) bzw. (b) entstehen an den belichteten Stellen saure Gruppen, die dann nach dem erfindungsgemäßen Verfahren ausgelesen werden können.

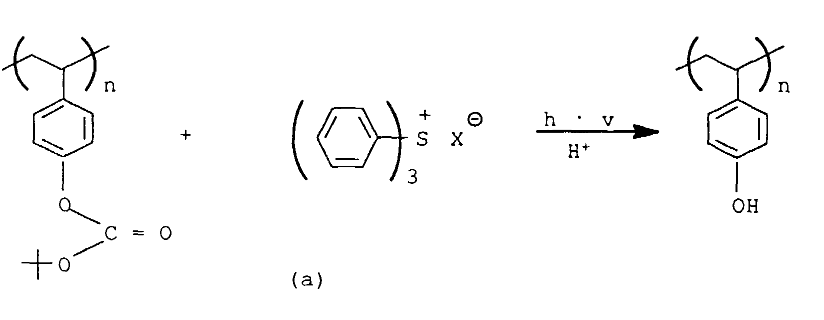

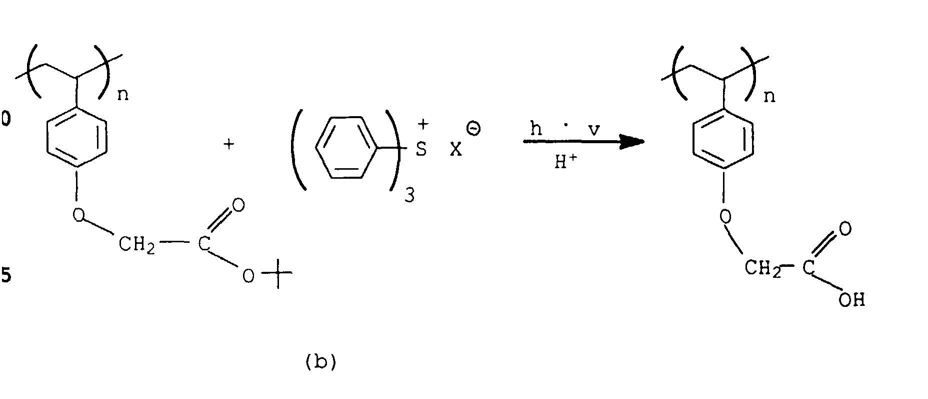

### Abbildungen:

### Fig. 1: Schema zum Prinzip der Rasterkraftmikroskopie

Die topographiebedingte Auslenkung des Hebelarmes wird über einen Lichtzeiger gemessen.

Es bedeuten 1 = Detektor, 2 = Laserlichtquelle, 3 = Piezoversteller, 4 = Spitze und Hebelarm, 5 = zu untersuchende Probe.

### Fig. 2: Durch Adsorption aus der flüssigen Phase beschichtete Spitze

Aufgrund der Affinität der Thiolgruppe zum Gold befinden sich die Säuregruppen außen, d.h. es liegt eine "saure Spitze" vor, die z.B. zum Nachweis basischer Gruppen oder von Wasserstoffbrückenbindungen geeignet ist.

4 und 5 haben die gleiche Bedeutung wie in Fig. 1. Weiter bedeuten 6 = aufgedampfte Goldschicht, 7 = Thiolcarbonsäure als selektive Schicht, 8 = Veranschaulichung der selektiven Wechselwirkung.

### Fig. 3: Schachbrettartige Modelloberfläche mit Bereichen, die Amino- oder Methylgruppen enthalten

5 hat die gleiche Bedeutung wie in Fig. 1. Weiter bedeuten 9 = hydrophile Schicht (in diesem Fall Tri-methoxy-propyl-aminosilan), 10 = hydrophobe Schicht (Tri-methoxy-butylsilan), 11 = Silicium-Maske.

### Fig. 4: Abbildung der Probe im Normalmodus der Rasterkraftmikroskpie mit unmodifizierter Spitze

Da die Probe praktisch keine Höhenunterschiede aufweist sondern nur Unterschiede in der chemischen Zusammensetzung, ergibt sich im reinen Topographiebild kein Kontrast. Die Oberfläche wirkt bis auf einige Fehlstellen glatt, die chemischen Unterschiede können nicht abgebildet werden.

### Fig. 5: Abbildung der Probe mit beschichteter Spitze

In diesem Fall wird im Normalkraft-Modus aufgrund der spezifischen Wechselwirkung zu den verschiedenen Bereichen der Probe eine Abbildung möglich. Es ergibt sich ein Kontrast aufgrund der chemischen Zusammensetzung der Probe, so daß eine Abbildung der chemischen Struktur der Oberfläche möglich wird.

### Fig. 6: Abbildung einer Haaroberfläche, welche sehr dünn mit Polymeren belegt ist

Die Polymerbelegung ist in der Bildmitte erkennbar. Ohne die beschichtete Spitze lassen sich die Polymere nicht direkt nachweisen.

### Fig. 7: Bedeckung eines Latexkügelchens aus Polystyrol mit dem Polyelektrolyten Polyethylenimin

Die beschichtete Spitze erlaubt den Nachweis der Polymerbelegung. Die Polyethyleniminpolymere sind als Erhebungen auf der Oberfläche der Latex-Kugel zu sehen.

## Patentansprüche

1. Verfahren zur chemisch differenzierenden Abbildung mittels Rasterkraftmikroskopie unter Verwendung chemisch modifizierter Sonden, wobei eine als Sonde eingesetzte chemisch modifizierte Spitze über die abzubildende Oberfläche mit konstanter Abstoßungskraft bewegt wird und der Abstand zwischen Spitze und Oberfläche im Bereich der Van der Waals'schen Abstoßungskräfte liegt, und die Konstanz der Abstoßungskräfte durch einen Piezoversteller aufrechterhalten wird, dadurch gekennzeichnet, daß die chemisch modifizierte Spitze entweder direkt oder nach Aufbringen einer Metall- oder Oxidschicht beschichtet ist mit wenigstens einer Substanz, die selektive Wechselwirkungen zur untersuchenden Oberfläche aufweist, und daß die die Spitze modifizierende Substanz ein Thiol mit zusätzlicher saurer oder basischer Funktionalität, ein Thiol mit zusätzlicher Nukleinbasenfunktionalität, ein Disulfid mit zusätzlicher saurer oder basischer Funktionalität oder ein Disulfid mit zusätzlicher Nukleinbasenfunktionalität eingesetzt wird, und daß die Abbildung im Normalkraft-, Elastizitäts-, Tapping- oder Non-Contact Modus erfolgt, so daß sich eine zweidimensionale, vergrößerte Abbildung der chemischen Zusammensetzung der zu untersuchenden Oberfläche ergibt.

2. Verfahren zur chemisch differenzierenden Abbildung mittels Rasterkraftmikroskopie unter Verwendung chemisch modifizierter Sonden, wobei eine als chemisch modifizierte Sonde eingesetzte Spitze über die abzubildende Oberfläche mit konstanter Abstoßungskraft bewegt wird und der Abstand zwischen Spitze und Oberfläche im Bereich der Van der Waals'schen Abstoßungskräfte liegt, und die Konstanz der Abstoßungskräfte durch einen Piezoversteller aufrechterhalten wird, dadurch gekennzeichnet, daß die chemisch modifizierte Spitze mit einem Polykation, mit einem Polyanion, mit einer organischen oder anorganischen Säure, mit einer organischen oder anorganischen Base oder mit einer Lewis-Säure beschichtet ist, wobei die Säure bzw. Base auch in polymerer Form vorliegen können, und daß die Abbildung im Normalkraft- Elastizitäts-, Tapping-< oder Non-Contact Modus erfolgt, so daß sich eine zweidimensionale, vergrößerte Abbildung der chemischen Zusammensetzung der zu untersuchenden Oberfläche ergibt.

3. Verfahren nach einem der Ansprüche 1 und 2, dadurch gekennzeichnet, daß die Abbildung in organischem Lösungsmittel, Wasser oder unter physiologischen Bedingungen erfolgt.

4. Verwendung des Verfahrens nach einem der vorgehenden Ansprüche zur Abbildung technischer Oberflächen.

5. Verwendung des Verfahrens nach einem der Ansprüche 1 bis 3 zur Abbildung von Substanzen mit Klebereigenschaften.

6. Verwendung des Verfahrens nach einem der Ansprüche 1 bis 3 zur Abbildung von biologischen Proben.

7. Verwendung des Verfahrens nach einem der Ansprüche 1 bis 3 zum Zwecke des Screenings oder Massenscreenings im Wirkstoffbereich.

8. Verwendung des Verfahrens nach einem der Ansprüche 1 bis 3 zum Speichern und Auslesen von Informationen.

## Claims

1. A process for chemically differentiating imaging by means of scanning atomic force microscopy using chemically modified probes, where a chemically modified tip employed as probe is moved over the surface to be imaged with a constant repulsive force, and the distance between the tip and the surface is in the region of van der Waal's repulsive forces, and the repulsive forces are kept constant by a piezoregulator, wherein the chemically modified tip is coated, either directly or after application of a metal or oxide layer, with at least one substance which has selective interactions with the surface to be analyzed, and wherein the tip-modifying substance is a thiol having additional acidic or basic functionality, a thiol having additional nucleic base functionality, a disulfide having additional acidic or basic functionality or a disulfide having additional nucleic base functionality, and wherein the imaging is carried out in normal force mode, elasticity mode, tapping mode on non-contact mode, giving a two-dimensional, magnified image of the chemical composition of the surface to be analyzed.

2. A process for chemically differentiating imaging by means of scanning atomic force microscopy using chemically modified probes, where a tip employed as chemically modified probe is moved over the surface to be imaged with a constant repulsive force, and the distance between the tip and the surface is in the region of van der Waal's repulsive forces, and the repulsive forces are kept constant by a piezoregulator, wherein the chemically modified tip is coated with a polyanion, with an organic or inorganic acid, with an organic or inorganic base or with a Lewis acid, where the acid or base can also be in polymeric form, and wherein the imaging is carried out in normal force mode, elasticity mode, tapping mode on non-contact mode, giving a two-dimensional, magnified image of the chemical composition of the surface to be analyzed.

3. A process as claimed in either of claims 1 and 2, wherein the imaging is carried out in an organic solvent, water or under physiological conditions.

4. The use of a process as claimed in one of the preceding claims for imaging industrial surfaces.

5. The use of a process as claimed in any one of claims 1 to 3 for imaging substances having adhesive properties.

6. The use of a process as claimed in any one of claims 1 to 3 for imaging biological samples.

7. The use of a process as claimed in any one of claims 1 to 3 for the purpose of screening or mass screening in the active ingredient area.

8. The use of a process as claimed in any one of claims 1 to 3 for storing and reading information.

## Revendications

1. Procédé d'imagerie à différenciation chimique au moyen d'un microscope à balayage à force atomique en utilisant des sondes chimiquement modifiées, où une pointe chimiquement modifiée, utilisée comme sonde, se déplace sur la surface à imager avec une force de répulsion constante, la distance entre la pointe et la surface se situant dans la zone des forces de répulsion de Van der Waals, et la force de répulsion étant maintenue constante par un piézorégleur, caractérisé en ce que la pointe chimiquement modifiée est recouverte, directement ou après application d'une couche de métal ou d'oxyde, d'une substance présentant des interactions sélectives vis-à-vis de la surface à étudier, et que la substance modifiant la pointe est un thiol à fonctionnalité additionnelle acide ou basique, un thiol à fonctionnalité nucléobasique additionnelle, un disulfure à fonctionnalité acide ou basique additionnelle ou un disulfure à fonctionnalité nucléobasique additionnelle, et que l'imagerie est entreprise en mode à force normale, élasticité, tapping ou sans contact, de manière à obtenir une représentation bidimensionnelle agrandie de la composition chimique de la surface à étudier.

2. Procédé d'imagerie à différenciation chimique au moyen d'un microscope à balayage à force atomique en utilisant des sondes chimiquement modifiées, où une pointe chimiquement modifiée, utilisée comme sonde, se déplace sur la surface à imager avec une force de répulsion constante, la distance entre la pointe et la surface se situant dans la zone des forces de répulsion de Van der Waals, et la force de répulsion étant maintenue constante par un piézorégleur, caractérisé en ce que la pointe chimiquement modifiée est revêtue d'un polycation, d'un polyanion, d'un acide organique ou inorganique, d'une base organique ou inorganique ou d'un acide de Lewis, l'acide et/ou la base pouvant également se présenter sous forme polymère, et en ce que l'imagerie est entreprise en mode à force normale, élasticité, tapping ou sans contact, de manière à obtenir une représentation bidimensionnelle agrandie de la composition chimique de la surface à étudier.

3. Procédé selon l'une des revendications 1 et 2, caractérisé en ce que l'imagerie est entreprise dans un solvant organique, de l'eau ou en milieu physiologique.

4. Utilisation du procédé selon l'une des revendications ciavant pour l'imagerie de surfaces techniques.

5. Utilisation du procédé selon l'une des revendications 1 à 3 pour l'imagerie de substances à propriétés collantes.

6. Utilisation du procédé selon l'une des revendications ciavant pour l'imagerie de spécimens biologiques.

7. Utilisation du procédé selon l'une des revendications ciavant pour le criblage ou le criblage de masse au niveau d'agents actifs.

8. Utilisation du procédé selon l'une des revendications ciavant pour l'enregistrement et la lecture d'informations.
